# EUROPÄISCHE PATENTSCHRIFT

(11) **EP 1 294 014 B1**
(45) Veröffentlichungstag und Bekanntmachung des Hinweises auf die Patenterteilung: **22.02.2012**
(21) Anmeldenummer: 02019577.2
(22) Anmeldetag: 02.09.2002
(51) Int. Cl.: H01L 21/683

(54) **Vorrichtung zum Handhaben von Platten**
Plate manipulation device
Dispositif de manipulation de plaques

(30) Priorität: 13.09.2001 DE 10145049
(43) Veröffentlichungstag der Anmeldung: 19.03.2003
(73) Patentinhaber: Infineon Technologies AG, 85579 Neubiberg (DE)
(72) Erfinder: Aigner, Kurt, 9073 Viktring (AT); Binder, Alfred, 9500 Landskron (AT); Kroupa, Gerhard, 9500 Villach (AT); Matschitsch, Martin, 9181 Feistritz i. Ros. (AT); Michenthaler, Norbert, 9530 Bad Bleiberg (AT); Pucher, Gerhard, 9500 Villach (AT)
(74) Vertreter: Kindermann, Peter

(56) Entgegenhaltungen:
- EP-A- 1 091 389
- WO-A-00/41854
- DE-A1- 19 755 694
- DE-A1- 19 925 653
- US-A- 5 169 196

## Beschreibung

Die vorliegende Erfindung betrifft eine Vorrichtung zum Handling von Platten, insbesondere von Halbleiterscheiben, die an einem ersten Ort aufzunehmen und ihrer Lage zu verändern oder zu einem zweiten Ort zu transportieren sind.

Halbleiterscheiben oder -wafer sind bekanntlich sehr dünn und weisen bei einem Durchmesser in der Größenordnung von 2 bis 8 Zoll Scheibendicken auf, die in der Größenordnung von einigen 10 bis einigen 100 µm liegen. Solche Halbleiterscheiben werden bisher zumeist manuell bzw. mit einem Handlingsystem von einem ersten Prozessierungsort zu einem zweiten Prozessierungsort gebracht. In der Praxis werden beispielsweise durch das Dünnschleifen ungewollt oft verbogene Halbleiterscheiben erzeugt, die sowohl konkave als auch konvexe Krümmungen enthalten. Diese Halbleiterscheiben können durch das Handlingsystem nicht mehr problemfrei gehandhabt werden. Daher werden sie im allgemeinen manuell mit Hilfe einer Pinzette aus einem entsprechenden Behälter entnommen und zur weiteren Prozessierung beispielweise in ein sogenanntes Quarz-Boot gebracht. Ein Quarz-Boot ist eine bestimmte Aufbewahrungskassette für Halbleiterscheiben. Der Einsatz einer Pinzette ist aber nicht unproblematisch, da dieser leicht zu teilweisen Beschädigungen, wie der Entstehung von Haarrissen und damit zu einem Ausfall von Chips in dem entsprechenden Bereich der Halbleiterscheibe führen kann.

Das Entnehmen und Einfügen von mechanisch wenig belastbaren Wafern aus oder in Materialträger (die bereits genannten Quarz-Boote, Kunststoffhorden o. ä.)muss zudem ohne Kantenkontakt mit diesen Behältern erfolgen, da bei Kantenkontakt sowohl die dünnen Wafer als auch die Behälter beschädigt würden, denn derartig dünne Wafer sind Rasierklingen ähnlich scharf.

Durch punktuelle Aufnahme mittels herkömmlicher Pinzetten ist der dünne Wafer nicht ausreichend unterstützt. Daher neigt ein so gehandhabter Wafer über die bereits erwähnten Probleme hinaus leicht zum Schwingen. Die Waferverbiegung hervorgerufen durch Verspannung des Wafers erschwert die Be- und Entstückung für den Operator. Die scharfen Kanten der Wafer schneiden in den schmalen Schlitzen der Behälter in die Materialstege und das führt unweigerlich zum Bruch des Wafers und zu Beschädigungen am Behälter.

Aus der DE 199 48 572 A1 ist eine sogenannte pneumatische Pinzette zur Handhabung von Dünnwafern bekannt. Die dort gezeigte und beschriebene Pinzette weist einen als Düsenplatte ausgebildeten Teller auf, welcher in seinem Zentrum eine Vakuumbohrung aufweist, und der am Umfang zahlreiche Düsenbohrungen enthält, die zur Erzeugung eines sogenannten Bernoulli-Prinzips dienen, welches auch als Bernoulli-Effekt bekannt ist. Unter diesem Bernoulli-Effekt ist die Bildung eines hydrodynamischen Unterdrucks zu verstehen, welcher dadurch entsteht, dass aus dem Zentrum einer Düsenplatte Gas durch nach außen gerichtete Düsen in die Randbereiche der Düsenplatte strömt und dabei im Zentrum ein geringerer Luftdruck herrscht, als in den Außenbereichen, in welche das Gas vom Zentrum aus strömt. Dünne Waferscheiben können mit einer derartigen pneumatischen Pinzette, deren Funktion auf dem vorbeschriebenen Effekt beruht, verhältnismäßig gut gehandhabt werden, da die Kombination von Bernoulli-Effekt und Vakuum als berührungslose Halteelemente für Waferscheiben entscheidende Vorteile hat.

Aus der Druckschrift DE 197 55 694 A1 ist eine Vorrichtung zum Transport von Wafern bekannt, wobei die Vorrichtung einen Träger umfasst, in dem Gaskanäle zur Nutzung des Bernoulliprinzips angeordnet sind, sowie über die Oberfläche des Trägers vorstehende Führungsarme. Das Dokument US 5,169,196 A zeigt einen Träger zum Aufnehmen von Halbleiterplättchen mit einem Aufnahmekopf, in dem Bohrungen zum Erzeugen des Bernoulli-Effekts angeordnet sind. An den Rändern des Aufnahmekopfes sind Finger angeordnet, die das Halbleiterplättchen relativ zum Aufnahmekopf zentrieren.

Demgegenüber ist es Aufgabe der vorliegenden Erfindung, eine Vorrichtung zum Handling von Platten, beispielsweise Halbleiterscheiben zu schaffen, die ein sicheres Transportieren und Handhaben der Halbleiterscheiben, wie beispielsweise eine Be- und Entstückung in bzw. aus Behältern erlaubt, wobei die Vorrichtung eine möglichst geringe Masse aufweisen soll, um optimal bedient werden zu können. Ferner soll die überdeckte Fläche des zu handhabenden Wafers möglichst gering sein, damit sich weniger Fremdpartikel zwischen Halterung und Wafer einschleichen können. Außerdem soll der zu handhabende Wafer auch von seiner Rückseite einer optischen Kontrolle unterzogen werden können.

Diese Aufgabe wird bei einer Vorrichtung der eingangs genannten Art erfindungsgemäß durch eine Haltevorrichtung gelöst, deren Merkmale dem Anspruch 1 zu entnehmen sind. Vorteilhafte Ausgestaltungen der Haltevorrichtung sind den abhängigen Ansprüchen zu entnehmen.

Vorzugsweise weist die Haltevorrichtung zum hydrodynamischen

Halten der Halbleiterscheibe ein Zentrum auf, welches zumindest Düsenbohrungen zum Erzeugen eines hydrodynamischen Unterdrucks aufweist, wobei vom Zentrum sternförmig nach außen weisende Stützarme vorhanden sind, welche die zu handhabende Halbleiterscheibe zumindest in deren Außenbereich abstützen.

Auf diese Weise erhält man eine besonders vorteilhafte Vorrichtung, bei der mittels einer besonders filigranen Ausführungsform ein hydrodynamischer Unterdruck zwischen Haltevorrichtung und Halbleiterscheibe erzeugt wird und bei der wenigstens eine Saugbohrung zum zusätzlichen Ansaugen der Halbleiterscheibe durch Vakuum dient.

Die erfindungsgemäße Haltevorrichtung nutzt also sowohl den Bernoulli-Effekt zur Erzeugung eines hydrodynamischen Unterdrucks zwischen Haltevorrichtung und Halbleiterscheibe als auch ein gleichzeitiges Ansaugen durch eine Saugbohrung, die sich vorzugsweise im Zentrum der Haltevorrichtung befindet, aus, um die Halbleiterscheibe praktisch berührungsfrei an der Haltevorrichtung "haften" zu lassen, so dass sie sicher und zuverlässig transportiert und gehandhabt werden kann. Zerstörungen oder Beschädigungen der Halbleiterscheibe sind nicht zu befürchten, da diese von der Haltevorrichtung durch eine dünne Luftströmung weitestgehend getrennt ist. Damit kann die Halbleiterscheibe zerstörungs- und beschädigungsfrei manuell oder auch automatisch transportiert und gehandhabt weiden.

Weiterhin erfolgt eine weitgehende Planarisierung der Halbleiterscheibe infolge des hydrodynamischen Unterdruckes zwischen der Haltevorrichtung und der Halbleiterscheibe, so dass diese keine konkaven oder konvexen Krümmungen mehr aufweist, solange sie mit der erfindungsgemäßen Haltevorrichtung transportiert wird bzw. an dieser angebracht ist.

Dazu weist die Haltevorrichtung an den Endbereichen ihrer Stützarme Aufnahmekuppen auf, in denen Bohrungen zum Ansaugen der Halbleiterscheibe vorhanden sind.

Von besonderem Vorteil ist es, dass die Aufnahmekuppen der Haltevorrichtung kreisförmig und ballig ausgebildet sind.

Darüber hinaus ist es bei der Handhabung bestimmter Halbleiterscheiben von Vorteil, wenn die Aufnahmekuppen der Haltevorrichtung durch kreisringförmige Abschnitte gebildet werden, welche eine konvexe Oberflächengestaltung aufweisen.

Ferner kann es von Vorteil sein, wenn die Stützarme an ihren Endbereichen mittels eines Ringes miteinander verbunden sind, da diese Bauform die Neigung zu Schwingungen reduziert..

Wenn in dem Ring Ansaugöffnungen angeordnet sind, kann eine Halbleiterscheibe an ihrem Umfang stabil fixiert werden.

Von Vorteil ist es ebenfalls, wenn an den Stützarmen außerhalb der Endbereiche zusätzliche Stützelemente für die Halbleiterscheibe vorgesehen sind.

Da die Haltevorrichtung über einen Handgriff verfügt, durch welchen die Anschlüsse für die Gasversorgung und das Vakuum geführt werden, lässt sich die Haltevorrichtung sehr einfach an die Versorgungsnetze anstecken, wobei es besonders vorteilhaft ist, dass die Haltevorrichtung und der Handgriff trennbar ausgeführt sind, um einen eventuell notwendigen Austausch leicht vornehmen zu können.

Die Erzeugung des hydrodynamischen Unterdrucks zwischen der Haltevorrichtung und der Halbleiterscheibe durch die aus den Düsenbohrungen der Haltevorrichtung strömende Luft einerseits und die Erzeugung des Saugdrucks durch Ansaugen von Luft durch die Saugbohrung andererseits sind vorzugsweise getrennt steuerbar. Es ist also möglich, die erfindungsgemäße Haltevorrichtung zeitweise nur über den durch die Haltevorrichtung gelieferten Unterdruck und zeitweise nur über den durch die Saugbohrung erzeugten Saugdruck zu betreiben.

Die erfindungsgemäße Haltevorrichtung kann extrem dünn mit einer Bauhöhe von nur etwa 2 bis 3 mm ausgebildet werden. Damit ist es möglich, mit der Haltevorrichtung zwischen zwei übereinander in einer Horde liegenden Halbleiterscheiben einzugreifen und eine dieser Halbleiterscheiben aufzunehmen.

In einer Weiterbildung der Erfindung ist vorgesehen, dass auch im Randbereich der Haltevorrichtung, nämlich an den Enden der Stützarme zusätzliche Saugbohrungen vorgesehen sind. Haltevorrichtungen, die derartige zusätzliche Saugbohrungen im Endbereich der Stützarme aufweisen, haben sich als besonders vorteilhaft zum Bestücken von Quarzbooten mit Halbleiterscheiben erwiesen.

Wesentlich an der vorliegenden Erfindung ist also die gemeinsame Verwendung des nach Bernoulli erzeugten hydrodynamischen Unterdruckes, der ein "Haften" zwischen Halbleiterscheibe und Haltevorrichtung bewirkt einerseits, und wenigstens einer Saugbohrung andererseits, wobei die besonders filigrane Bauweise das Handling der zu haltenden Halbleiterscheibe noch erleichtert und eine deutlich verbesserte visuelle Kontrolle der Halbleiterscheibe ermöglicht.

Mit Hilfe von Ausführungsbeispielen wird die Erfindung anhand der Zeichnungen näher erläutert

Es zeigen:
Figur 1 eine schematische Darstellung einer erfindungsgemäßen Haltevorrichtung;
Figur 2 einen Handgriff einer Haltevorrichtung;
Figur 3 eine Variante einer Vorrichtung gemäß Figur 1 und
Figur4 eine weitere Variante.

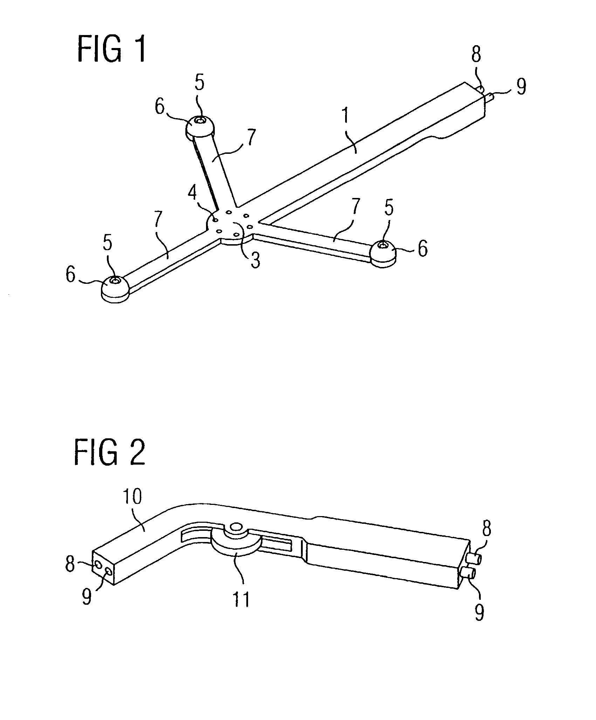

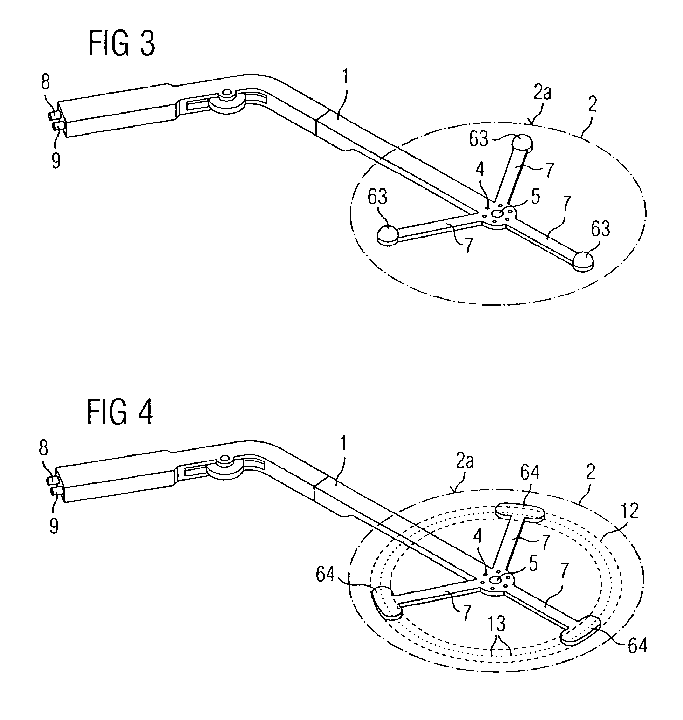

Die Darstellung in Figur 1 zeigt eine erfindungsgemäße Vorrichtung, die von einer Haltevorrichtung 1 zur Halterung von Halbleiterscheiben 2 gebildet wird. Die Halbleiterscheiben 2 sind in Figur 1 noch nicht dargestellt, sondern erst in den Figuren 3 und 4. Im Zentrum 3 der Haltevorrichtung 1 befindet sich eine Vielzahl von Düsenbohrungen 4, durch welche Gas ausströmen kann. Die Düsenbohrungen 4 sind unter einem Winkel zur Oberfläche des Zentrums 3 so geneigt, dass das ausströmende Gas von Zentrum 3 weg in die Außenbereiche der Haltevorrichtung 1 strömen kann. Dadurch entsteht im Zentrum 3 der Haltevorrichtung 1 ein gewisser Unterdruck, welcher als hydrodynamischer Unterdruck bezeichnet wird und den sogenannten Bernoulli-Effekt hervorruft. Eine auf der Haltevorrichtung 1 befindliche Halbleiterscheibe 2 wird durch diesen Bernoulli-Effekt praktisch berührungslos in der Schwebe über der Haltevorrichtung 1 gehalten.

Um eine laterale Verschiebung der Halbleiterscheibe 2 auf der Haltevorrichtung 1 zu verhindern, sind Ansaugbohrungen 5 in den Endbereichen 6 von Stützarmen 7 angeordnet. Diese Ansaugbohrungen 5 sind mit einer nicht dargestellten Unterdruckquelle verbunden und erzeugen ein gewisses Vakuum, welches die durch den Bernoulli-Effekt in der Schwebe gehaltene Halbleiterscheibe 2 in gewissem Maße fixiert.

Die in diesem Ausfuhrungsbeispiel gezeigte Haltevorrichtung 1 mit Ansaugbohrungen 5 in den Endbereichen 6 der Stützarme 7 ist nur eine Möglichkeit, Ansaugbohrungen 5 vorzusehen. Ebenso ist eine Ausführungsform realisierbar, bei der sich eine Ansaugbohrung (nicht dargestellt) im Zentrum 3 der Haltevorrichtung 1 befindet. In diesem Fall, der in der Praxis bevorzugt wird, können die Ansaugbohrungen in den Endbereichen der Stützarme 7 natürlich entfallen.

Bei der Erfindung sind die Stützarme 7 von besonderer Bedeutung, denn durch diese filigrane Ausführung können die Halbleiterscheiben 2 genauso gehalten werden, wie bei einer vollständig geschlossenen Düsenplatte gemäß dem Stand der Technik, diese jedoch deckt die zu haltende Halbleiterscheibe zumindest von einer Seite vollständig ab. Eine optische Prüfung der gehaltenen Halbleiterscheibe ist demgemäss auch nur von einer Seite möglich. Hier schafft die Erfindung Abhilfe, denn die Stützarme 7 decken die zu haltende Halbleiterscheibe 2 in der Praxis nur zu etwa 20% ab, so dass etwa 80% der Rückseite der gehaltenen Halbleiterscheibe 2 einer visuellen Überprüfung unterzogen werden können.

Diese filigrane Ausführung der Haltevorrichtung 1 hat den weiteren erheblichen Vorteil, dass ihre Masse deutlich geringer ist, als die mit einer geschlossenen Düsenplatte gemäss dem Stand der Technik. Die Handhabung durch das Bedienungspersonal ist dadurch natürlich wesentlich verbessert, was zu weniger Ausschuss und kürzeren Handlingzeiten führt.

Die Haltevorrichtung 1 hat zwei Medien-Anschlüsse, einen Gasanschluss 8 für ausströmendes Gas zur Erzeugung des Bernoulli-Effekts und einen zweiten, den Vakuumanschluss 9, zum Absaugen von Luft, also für die Erzeugung von Vakuum. Die Vorrichtung ist bevorzugt zweiteilig ausgeführt, und zwar besteht sie aus der eigentlichen Haltevorrichtung 1 und einem Handgriff 10, die zusammensteckbar sind. Im Handgriff 10 befindet sich ein Umschalter 11, mit dem die Quelle und Menge des jeweils ausgewählten Mediums gesteuert werden kann. Diese Bauform erweist sich als vorteilhaft, weil dann unterschiedliche Haltevorrichtungen 1 an den Handgriff 10 angesteckt werden können. Gleichzeitig mit der mechanischen Verbindung von Haltevorrichtung 1 und Handgriff 10 werden die Medien-Anschlüsse 8 und 9 für "Bernoulli-Gas" und "Vakuum" jeweils miteinander verbunden.

In Figur 3 ist eine einteilige Variante einer Haltevorrichtung 1 dargestellt. Gleiche Bezugszeichen deuten auf funktionsgleiche Elemente hin Zur Vermeidung von Wiederholungen wird nur auf die Unterschiede zum Ausführungsbeispiel gemäß Figur 1 eingegangen. Die Haltevorrichtung 1 ist einstückig ausgebildet und trägt im Zentrum 3 sowohl Düsenbohrungen 4 als auch eine Ansaugbohrung 5. Die Stützarme 7 enden in ballig geformten kreisförmigen Aufnahmekuppen 63, auf denen der Außenbereich der Halbleiterscheibe 2 mit geringstem Druck punktuell gerade so aufliegt, dass Planheit gegeben ist und ein Schwingen vermieden wird.

In Figur 4 ist eine Variante der Ausführungsform nach Figur 3 dargestellt. Hier sind die Endbereiche der Stützarme als kreisringförmige Abschnitte 64 ausgebildet, die etwas mehr Auflage für die Halbleiterscheibe 2 bieten, was in einigen Fällen vorteilhaft sein kann. Durch gestrichelte Linien ist angedeutet, dass die kreisringförmigen Abschnitte 64 Teile eines geschlossenen Ringes 12 sein können, der seinerseits Ansaugöffnungen 13 aufweist. Dieser Ring 12 stabilisiert die Haltevorrichtung 1, erhöht dessen Masse aber nur unwesentlich und die visuelle Prüfbarkeit der gehaltenen Oberflächenseite der Halbleiterscheibe 2 verringert sich auch nur unwesentlich.

Es soll auch eine Ausführungsform nicht ausgeschlossen werden, bei der außerhalb der Aufnahmekuppen 6, 63, 64 zumindest Teilbereiche der Stützarme 7 so ausgebildet sind, dass die Halbleiterscheibe 2 partiell abgestützt ist.

## Patentansprüche

1. Vorrichtung zum Handhaben von Platten, insbesondere zum Handhaben von Halbleiterscheiben mit einer pneumatisch arbeitenden Haltevorrichtung zum hydrodynamischen Halten der Halbleiterscheibe, wobei die Haltevorrichtung (1) durch ein Zentrum (3) gebildet wird, welches zumindest Düsenbohrungen (4) zum Erzeugen eines hydrodynamischen Unterdrucks aufweist, **dadurch gekennzeichnet, dass** vom Zentrum (3) sternförmig nach außen weisende Stützarme (7) vorhanden sind, welche die zu handhabende Halbleiterscheibe (2) zumindest in deren Außenbereich (2a) abstützen.

2. Vorrichtung nach Anspruch 1, **dadurch gekennzeichnet, dass** die Haltevorrichtung (1) in ihrem Zentrum (3) über eine zusätzliche Bohrung (5) zum Ansaugen der Halbleiterplatte (2) verfügt.

3. Vorrichtung nach Anspruch 1, **dadurch gekennzeichnet, dass** die Haltevorrichtung (1) an den Endbereichen ihrer Stützarme (7) Aufnahmekuppen (6, 63, 64) aufweist.

4. Vorrichtung nach Anspruch 3, **dadurch gekennzeichnet, dass** die Haltevorrichtung (1) in den Aufnahmekuppen (6) Bohrungen (5) zum Ansaugen der Halbleiterscheibe (2) aufweisen.

5. Vorrichtung nach Anspruch 3, **dadurch gekennzeichnet, dass** die Aufnahmekuppen (63) der Haltevorrichtung (1) kreisförmig und ballig ausgebildet sind.

6. Vorrichtung nach Anspruch 3, **dadurch gekennzeichnet, dass** die Aufnahmekuppen der Haltevorrichtung (1) durch kreisringförmige Abschnitte (64) gebildet werden, welche eine konvexe Oberflächengestaltung aufweisen.

7. Vorrichtung nach Anspruch 1, **dadurch gekennzeichnet, dass** die Stützarme (7) an ihren Endbereichen (64) mittels eines Ringes (12) miteinander verbunden sind.

8. Vorrichtung nach Anspruch 1, **dadurch gekennzeichnet, dass** im Ring (12) Ansaugöffnungen (13) angeordnet sind.

9. Vorrichtung nach Anspruch 1, **dadurch gekennzeichnet, dass** an den Stützarmen (7) außerhalb der Endbereiche (6, 63, 64) Stützelemente für die Halbleiterscheibe (2) vorgesehen sind.

10. Vorrichtung nach Anspruch 1, **dadurch gekennzeichnet, dass** die Haltevorrichtung (1)über einen Handgriff (10) verfügt, durch welchen die Anschlüsse(8, 9) für die Gasversorgung und das Vakuum geführt werden.

11. Vorrichtung nach Anspruch 1, **dadurch gekennzeichnet, dass** die Haltevorrichtung (1) und der Handgriff (10) trennbar ausgeführt sind.

## Claims

1. Apparatus for board handling, in particular for handling semiconductor wafers using a pneumatically operating holding apparatus for hydrodynamically holding the semiconductor wafer, with the holding apparatus (1) being formed by a centre (3) which has at least nozzle holes (4) in order to produce a hydrodynamic reduced pressure, **characterized in that** supporting arms (7) which point outwards in the form of a star from the centre (3) are present, which supporting arms support the semiconductor wafer (2) to be handled, at least in its outer area (2a).

2. Apparatus according to Claim 1, **characterized in that** the holding apparatus (1) has an additional hole (5) at its centre (3), for applying suction to the semiconductor board (2).

3. Apparatus according to Claim 1, **characterized in that** the holding apparatus (1) has retaining combs (6, 63, 64) adjacent to the end areas of its supporting arms (7).

4. Apparatus according to Claim 3, **characterized in that** the holding apparatus (1) has holes (5) in the retaining combs (6), for applying suction to the semiconductor wafer (2).

5. Apparatus according to Claim 3, **characterized in that** the retaining combs (63) of the holding apparatus (1) are circular and spherical.

6. Apparatus according to Claim 3, **characterized in that** the retaining combs of the holding apparatus (1) are formed by sections (64) which are in the form of circular rings and have a convex surface shape.

7. Apparatus according to Claim 1, **characterized in that** the supporting arms (7) are connected to one another by means of a ring (12) at their end areas (64).

8. Apparatus according to Claim 1, **characterized in that** suction openings (13) are arranged in the ring (12).

9. Apparatus according to Claim 1, **characterized in that** supporting elements for the semiconductor wafer (2) are provided on the supporting arms (7), away from the end areas (6, 63, 64).

10. Apparatus according to Claim 1, **characterized in that** the holding apparatus (1) has a handle (10) through which the connections (8, 9) for the gas supply and the vacuum are passed.

11. Apparatus according to Claim 1, **characterized in that** the holding apparatus (1) and the handle (10) are designed such that they can be separated.

## Revendications

1. Dispositif de manipulation de plaques, notamment de manipulation de tranches semiconductrices, comprenant un dispositif de support travaillant pneumatiquement, pour le support hydrodynamique de la tranche semiconductrice, dans lequel le dispositif (1) de support est formé par un centre (3), qui comporte au moins des trous (4) de buse pour la production d'une dépression hydrodynamique, **caractérisé en ce qu'**il y a des bras (7) d'appui, partant du centre (3) en forme d'étoile vers l'extérieur et soutenant la tranche (2) semiconductrice à manipuler au moins dans sa partie (2a) extérieure.

2. Dispositif suivant la revendication 1, **caractérisé en ce que** le dispositif (1) de support dispose en son centre (3) d'un trou (5) supplémentaire d'aspiration de la tranche (2) semiconductrice.

3. Dispositif suivant la revendication 1, **caractérisé en ce que** le dispositif (1) de support a des coupelles (6, 63, 64) de réception aux parties d'extrémité de ses bras (7) d'appui.

4. Dispositif suivant la revendication 3, **caractérisé en ce que** le dispositif (1) de support a, dans les coupelles (6) de réception, des trous (5) d'aspiration de la tranche (2) semiconductrice.

5. Dispositif suivant la revendication 3, **caractérisé en ce que** les coupelles (63) de réception du dispositif (1) de support sont de forme circulaire et bombées.

6. Dispositif suivant la revendication 3, **caractérisé en ce que** les coupelles de réception du dispositif (1) de support sont formées par des segments (64) annulaires, qui ont une configuration de surface convexe.

7. Dispositif suivant la revendication 1, **caractérisé en ce que** les bras (7) d'appui sont reliés entre eux à leurs parties (64) d'extrémité au moyen d'un anneau (12).

8. Dispositif suivant la revendication 1, **caractérisé en ce que** des ouvertures (13) d'aspiration sont pratiquées dans l'anneau (12).

9. Dispositif suivant la revendication 1, **caractérisé en ce qu'**il est prévu sur les bras (7) d'appui en-dehors des parties (6, 63, 64) d'extrémité des éléments d'appui de la tranche (2) semiconductrice.

10. Dispositif suivant la revendication 1, **caractérisé en ce que** le dispositif (1) de support dispose d'une poignée (10), dans laquelle passent les raccords (8, 9) pour l'alimentation en gaz et le vide.

11. Dispositif suivant la revendication 1, **caractérisé en ce que** le dispositif (1) de support et la poignée (10) sont réalisés de manière séparable.
